# EUROPEAN PATENT APPLICATION

(11) **EP 3 059 858 A1**
(43) Date of publication of application: **24.08.2016**
(21) Application number: 15156065.3
(22) Date of filing: 23.02.2015
(51) Int. Cl.: H03F 1/02, H03F 3/217, H03F 3/24

(54) **Method and apparatus for supplying power to an amplifier**

(71) Applicant: Nokia Technologies OY, 02610 Espoo (FI)
(72) Inventor: Nentwig, Markus, 00200 Helsinki (FI)
(74) Representative: Nokia Corporation

(57) **Abstract**

There are disclosed various methods and apparatuses for providing power to a power amplifier. In some embodiments the method comprises producing a first reference signal having a level above a target signal, and producing a second reference signal having a level below the target signal. A positive supply voltage that tracks the first reference signal and a negative supply voltage that tracks the second reference signal are provided to a driver. A signal corresponding to the target signal is supplied from the driver to a power amplifier. In some embodiments the apparatus comprises means for implementing the method.

## Description

### TECHNICAL FIELD

The present invention relates to a method for supplying power to an amplifier and an apparatus for supplying power to an amplifier.

### BACKGROUND

This section is intended to provide a background or context to the invention that is recited in the claims. The description herein may include concepts that could be pursued, but are not necessarily ones that have been previously conceived or pursued. Therefore, unless otherwise indicated herein, what is described in this section is not prior art to the description and claims in this application and is not admitted to be prior art by inclusion in this section.

In some apparatuses which are able to transmit and receive signals wirelessly and which may be battery powered may utilize so called switched-mode power supplies (SMPS) to supply power to a radio frequency (RF) power amplifier (PA) of a transmitter. Achieving a high bandwidth for signals beyond e.g. about 10 MHz bandwidth may require a linear amplifier stage in the switched-mode power supplies, such as an envelope tracking power source (ET modulator). Unwanted power dissipation in the linear amplifier may be proportional to sourced or sinked current and voltage drop over a power transistor of the power amplifier. Such battery-operated wireless communication devices are, for example, mobile phones, personal digital assistants (PDA), etc. The power amplifier(s) may determine a large portion of the total power consumption of such devices. Batteries with low supply voltage, e.g. about 3V, may be employed in the portable devices.

### SUMMARY

Various embodiments provide a method and apparatus for supplying power to a power amplifier of a transmitter.

Various aspects of examples of the invention are provided in the detailed description.

According to a first aspect, there is provided a method comprising:
producing a first reference signal having a level above a target signal;
producing a second reference signal having a level below the target signal;
providing a positive supply voltage that tracks the first reference signal to a driver;
providing a negative supply voltage that tracks the second reference signal to the driver; and
supplying a signal corresponding to the target signal to a power amplifier from the driver.

According to a second aspect, there is provided an apparatus comprising:
a first element for producing a first reference signal having a level above a target signal;
a second element for producing a second reference signal having a level below the target signal;
a third element for providing a positive supply voltage that tracks the first reference signal to a driver;
a fourth element for providing a negative supply voltage that tracks the second reference signal to the driver;
wherein the driver comprises an output for supplying a signal corresponding to the target signal to a power amplifier.

According to a third aspect, there is provided an apparatus comprising at least one processor and at least one memory including computer program code, the at least one memory and the computer program code configured to, with the at least one processor, cause the apparatus to:
produce a first reference signal having a level above a target signal; and
produce a second reference signal having a level below the target signal;
wherein the apparatus is adapted to:
   provide a positive supply voltage that tracks the first reference signal to a driver;
   provide a negative supply voltage that tracks the second reference signal to the driver; and
   supply a signal corresponding to the target signal to a power amplifier from the driver.

According to a fourth aspect, there is provided a computer program product including one or more sequences of one or more instructions which, when executed by one or more processors, cause an apparatus to at least perform the following:
produce a first reference signal having a level above a target signal; and
produce a second reference signal having a level below the target signal;
wherein the apparatus is adapted to:
   provide a positive supply voltage that tracks the first reference signal to a driver;
   provide a negative supply voltage that tracks the second reference signal to the driver; and
   supply a signal corresponding to the target signal to a power amplifier from the driver.

According to a fifth aspect, there is provided an apparatus comprising:
means for producing a first reference signal having a level above a target signal; and
means for producing a second reference signal having a level below the target signal;
means for providing a positive supply voltage that tracks the first reference signal to a driver;
means for providing a negative supply voltage that tracks the second reference signal to the driver; and
means for supplying a signal corresponding to the target signal to a power amplifier from the driver.

### BRIEF DESCRIPTION OF THE DRAWINGS

For a more complete understanding of example embodiments of the present invention, reference is now made to the following descriptions taken in connection with the accompanying drawings in which:
Figure 1 shows a simplified block diagram of a device according to an example embodiment;
Figure 2a illustrates an example of an apparatus for providing power to a power amplifier, in accordance with an embodiment;
Figure 2b illustrates an example of an element of the apparatus as a simplified diagram, in accordance with an embodiment;
Figure 3a illustrates some signal waveforms in connection with the apparatus, in accordance with an embodiment;
Figure 3b illustrates some signal waveforms in connection with the apparatus, in accordance with another embodiment;
Figure 4 shows a block diagram of an apparatus according to an example embodiment;
Figure 5 shows an apparatus according to an example embodiment;
Figure 6 shows an example of an arrangement for wireless communication comprising a plurality of apparatuses, networks and network elements.

### DETAILED DESCRIPTON OF SOME EXAMPLE EMBODIMENTS

The following embodiments are exemplary. Although the specification may refer to "an", "one", or "some" embodiment(s) in several locations, this does not necessarily mean that each such reference is to the same embodiment(s), or that the feature only applies to a single embodiment. Single features of different embodiments may also be combined to provide other embodiments.

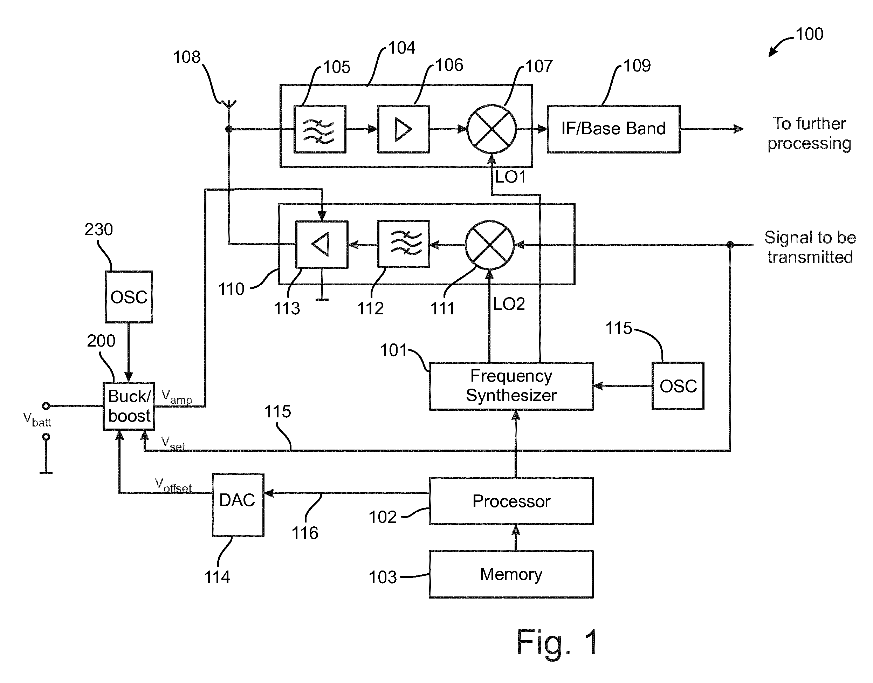

Figure 1 depicts an example of a part of a device 100, which may be, for example, a mobile device such as a mobile phone, but may also be another device comprising the power amplifier 113. The device 100 may be constructed to include the frequency synthesizer 101 for generating one or more oscillator signals. The device comprises one or more data processors 102 for controlling the operation of the device, in accordance with an embodiment. The data processor 102 operates in accordance with program instructions stored in at least one storage medium, such as at least one memory 103. The data processor 102 may control the frequency synthesizer 101 for setting the output frequency/frequencies of the frequency synthesizer 101. These output frequencies form one or more local oscillator signals that may be applied simultaneously to an RF receiver circuitry 104. The RF receiver circuitry 104 may include one or multiple instances of filters 105, amplifiers 106 and mixers 107. The RF receiver circuitry 104 may be configured to be connected with at least one, and possibly several antennas 108, and may operate to simultaneously receive and downconvert multiple reception channels in multiple frequency bands. The RF receiver circuitry 104 may be implemented e.g. as a single direct conversion receiver, as a plurality of direct conversion receivers, as a single superheterodyne-type receiver or as a plurality of superheterodyne-type receivers. In either case the downconverted signals from multiple reception channels are provided to at least one baseband circuitry block 109 to demodulate and decode received signaling and other data.

The device of Figure 1 also comprises an RF transmitter 110 for transmitting radio frequency signals. The transmitter 110 may comprise one or more mixers 111 adapted to receive signals to be transmitted and a local oscillator signal LO2. The mixing result may be provided to a band pass filter 112 to filter out mixing results which are out of the transmission band, and a power amplifier 113 to amplify the RF signals before passing them to one or more antennas 108. The one or more antennas 108 may be the same one or more antennas than the RF receiver circuitry 104 uses or different antenna(s).

The RF receiver circuitry 104, the RF transmitter 110 and/or the baseband circuitry 109 may be embodied as an integrated circuit. In some embodiments both the RF receiver circuitry 104, the RF transmitter 110 and the baseband circuitry 109 may be embodied in the same integrated circuit, and in some other embodiments they may be embodied in different integrated circuits. In some embodiments all of the circuitry shown in Figure 1, including the data processor 102 and possibly also the memory 103, may be embodied in one integrated circuit module or package.

In some embodiments all or some of the functionality of the frequency synthesizer 101 may be embodied by the data processor 102 or by another data processor, such as a high speed digital signal processor operating under control of a stored program.

The device of Figure 1 also comprises an apparatus 200 for supplying power to the power amplifier 113 of the transmitter 110 of the device 100. The apparatus 200 may be controlled by the processor 102, for example. The processor 102 may generate a control signal 116 to a digital-to-analog converter 114 (DAC). The control signal 116 may be used to generate an offset voltage V_{offset} by the digital-to-analog converter 114. A target voltage Vₛₑₜ may be obtained 115 on the basis of the signal to be transmitted. The target voltage Vₛₑₜ indicates a desired output voltage Vamp which the apparatus 200 should generate to the power amplifier 113. The offset voltage V_{offset} may be used together with the desired output voltage Vₛₑₜ to indicate the apparatus an upper bound and a lower bound of the output voltage Vamp.

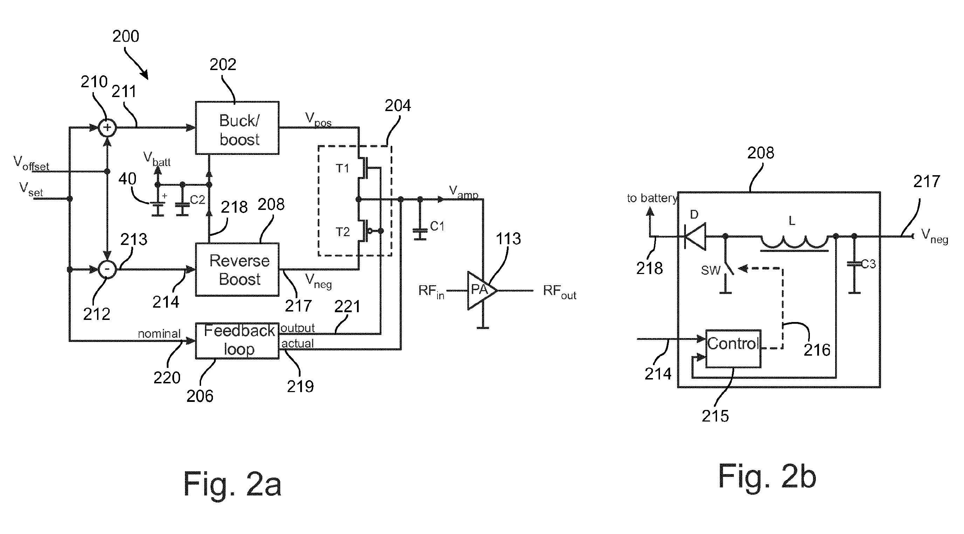

An example embodiment of the apparatus 200 is depicted in Figure 2a. The apparatus 200 may comprise a first switching-mode power supply (SMPS) 202, a second switching-mode power supply 208, a driver 204 for providing power from the switched-mode power supplies 202, 208 to the power amplifier 113, and a feedback loop 206. The output of the driver 204 may be coupled to a first feedback input 219 of the feedback loop 206, and desired output voltage Vₛₑₜ may be coupled to a second feedback input 220 of the feedback loop 206. The feedback loop 206 may then compare the output voltage Vamp (actual) with the desired output voltage Vₛₑₜ (nominal) and produce an output signal 221, which may be used to control the transistors T1, T2 of the output stage of the driver 204 so that the output of the driver 204 may track the desired output voltage level.

The driver 204 may be an electronic circuit which is capable of supplying current to the power amplifier 113 and sinking current from the power amplifier. Hence, the driver 204 may be regarded as an amplifier or a buffer. In some embodiments the driver 204 may be a linear amplifier. A linear amplifier is an electronic circuit which may produce an output signal which is substantially linearly proportional to an input signal of the linear amplifier. The output signal may be capable of delivering more power into a load than the input signal. An example of such linear amplifier configuration is a so-called push-pull topology in which a pair of active devices are connected in series between a positive supply and a negative supply. Such configuration may alternately supply current to, or sink current from, a connected load. Such pair of active devices may comprise, for example, a complementary pair of transistors such as mosfet transistors. One of the transistors may sink current from the load to ground or a negative power supply, and the other transistor may supply current to the load from a positive power supply.

It should be noted here that also non-linear amplifiers may be used as the driver 204, in accordance with an embodiment. Hence, the output provided by the non-linear amplifier may not be linearly dependent on the input of the non-linear amplifier.

In order to get high efficiency from the power amplifier, the switching-mode power supply, which may also be called as a boost converter or a step-up converter, may be needed to raise the supply voltage of the power amplifier to a value higher than a maximum battery voltage. To improve efficiency also at small transmission power levels, the supply voltage of the power amplifier may be lowered. For that purpose another type of switching-mode power supply (may be called as a buck converter, or a step-down converter) may be utilized for providing a supply voltage of the power amplifier that is to lower than the battery. The boost and buck converter may be cascaded or in a parallel configuration, for example. Such a configuration may be called as a buck-boost type switching converter. If the boost and buck converter are cascaded, the buck converter may be supplied by the output of the boost converter. In parallel configuration both converters may be directly supplied from the battery, wherein the buck converter need not achieve so large voltage reduction than in the cascaded configuration. The boost converter, the buck converter or both may also comprise by-pass circuitry wherein the battery may supply energy to the power amplifier directly without using the converter(s).

In the following the operation of the apparatus 200 of Figure 2a will be explained in more detail, in accordance with an embodiment. It is assumed that the first switching-mode power supply 202 and the second switching-mode power supply 208 comprise control electronics for controlling the operation of the switching-mode power supply 202, 208 and also oscillator circuitry for providing oscillating signals to switches of the switching-mode power supply 202, 208. The switching-mode power supply 202, 208 may comprise a hysteretic switching regulator. However, in accordance with an embodiment, control of the switching-mode power supplies 202, 208 may be performed by the processor 102 of the device 100 and/or the oscillator signals (if any) for the operation of the switching-mode power supplies 202, 208 may be generated from the oscillator 230 or from the local oscillator signal e.g. by the frequency synthesizer 101.

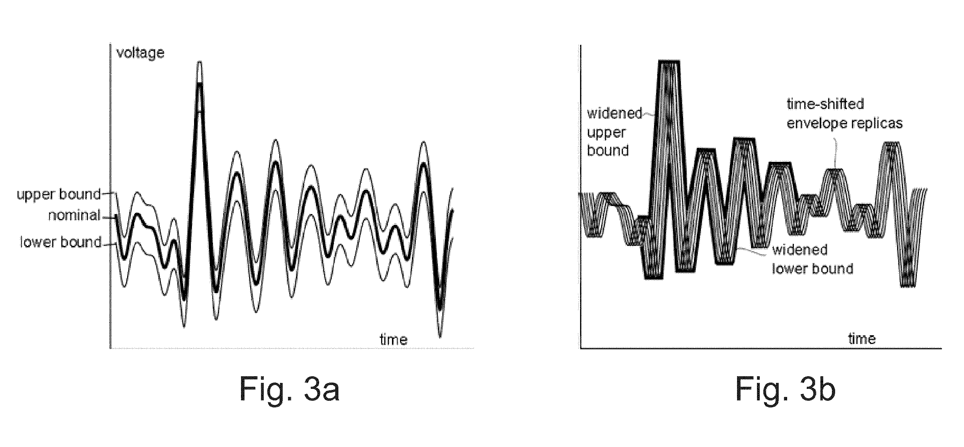

The target voltage Vₛₑₜ is connected to an adder 210 and to a subtractor 212 of the apparatus 200. The offset voltage V_{offset} is also connected to the adder 210 and the subtractor 212. The adder 210 outputs 211 a voltage which is the sum of the target voltage and the offset voltage, i.e. Vₛₑₜ+V_{offset}. Correspondingly, the subtractor 212 outputs 213 a voltage which is the target voltage subtracted by the offset voltage, i.e. Vₛₑₜ-V_{offset}. Figure 3a illustrates an example of waveforms of the target voltage and the output voltages 211, 213 from the adder 210 and the subtractor 212.

The output voltage 211 from the adder 210 is connected to a control voltage input of the first switching-mode power supply 202. The control logic of the first switching-mode power supply 202 adjusts a duty cycle of the switches of the first switching-mode power supply 202 so that the output voltage Vₚₒₛ from the first switching-mode power supply 202 follows the voltage at the control voltage input of the first switching-mode power supply 202. It should be noted here that the output voltage Vₚₒₛ from the first switching-mode power supply 202 may not be exactly equal to the voltage at the control voltage input of the first switching-mode power supply 202 but due to inaccuracies such as switching ripple in the circuitry of the first switching-mode power supply 202 the output voltage Vₚₒₛ may be slightly different from the voltage at the control voltage input of the first switching-mode power supply 202.

The output voltage 213 from the subtractor 212 is connected to a control voltage input 214 (Figure 2b) of the second switching-mode power supply 208. The control logic of the second switching-mode power supply 208 controls a switch of the second switching-mode power supply 208 so that the output voltage V_{neg} from the second switching-mode power supply 208 follows the voltage at the control voltage input of the second switching-mode power supply 208 i.e. Vₛₑₜ-V_{offset}. This will be explained in more detail later in this specification. It should be noted also here that the output voltage V_{neg} from the second switching-mode power supply 208 may not be exactly equal to the voltage at the control voltage input of the second switching-mode power supply 208 but due to inaccuracies such as switching ripple in the circuitry of the second switching-mode power supply 208 the output voltage V_{neg} may be slightly different from the voltage at the control voltage input of the second switching-mode power supply 208.

The output voltage Vₚₒₛ from the first switching-mode power supply 202 is connected to a positive voltage input of the driver 204 and the output voltage V_{neg} from the second switching-mode power supply 208 is connected to a negative voltage input of the driver 204. The driver 204 may be, for example, a linear amplifier.

Voltages appearing at different locations of the device 100 may in practice be between 0 V and a positive maximum voltage value, which may depend on the implementation. In other words, although the term negative voltage input has been used above, no voltages below 0 V may exist. However, in some embodiments the voltages need not all be above 0 V but also voltages below 0 V may exist. In yet some embodiments all the voltages may be 0 V or below 0 V, wherein details of the practical circuitry may differ from embodiments in which only positive voltages are used. However, the operating principles of the apparatus 100 may still be similar irrespective of the voltage levels used.

Figure 2b depicts an example of the second switching-mode power supply 208 as a simplified circuit diagram. The voltage Vₛₑₜ-V_{offset} provided by the subtractor 212 at the control voltage input 214 of the second switching-mode power supply 208 is monitored by a control element 215 of the second switching-mode power supply 208. The control element 215 may produce a control signal 216 to a switch SW of the second switching-mode power supply 208, wherein the switch SW is closed and opened based on the level of the control signal. The switch SW is coupled between the ground potential and an anode of a diode D. A first terminal of an inductor L is also coupled to the anode of the diode D and the switch SW. A second terminal of the inductor L is coupled to the negative voltage input 217 of the driver 204. The second switching-mode power supply 208 may further comprise a capacitor C3 coupled between the second terminal of the inductor L and the ground potential. A cathode of the diode D is coupled 218 to a positive potential of the battery 40. The control element 215 is also provided a signal which follows the voltage across the capacitor C3 which also corresponds with the voltage provided to the negative voltage input of the driver 204. The control element 215 compares the voltage across the capacitor C3 and the voltage at the control voltage input 214 of the second switching-mode power supply 208. If the voltage at the control voltage input 214 of the second switching-mode power supply 208 is less than the voltage across the capacitor C3, i.e. the voltage across the capacitor C3 should be decreased, switch SW may be closed. When the switch SW is closed, the anode of the diode D and the first terminal of the inductor L (e.g. a coil), is coupled to the ground potential and substantially zero or only very small current may flow through the diode to the battery 40. Instead, a current begins to flow from the capacitor C3 through the inductor L and the switch SW to the ground. Hence, the voltage across the capacitor C3 starts to decrease. The inductor L tries to oppose changes in the current flowing through the inductor L and stores energy taken from the capacitor C3. If the voltage at the control voltage input 214 of the second switching-mode power supply 208 becomes higher than the voltage across the capacitor C3, i.e. the voltage across the capacitor C3 should be increased, switch SW may be opened. When the switch 216 is opened, the anode of the diode D and the first terminal of the inductor L (e.g. a coil), are not coupled to the ground potential and substantially zero or only very small current may flow through the switch SW to the ground potential, but energy stored in the magnetic field of the inductor L begins to be transferred into the battery 40 via the diode D. Due to the above described operation of the second switching-mode power supply 208, the voltage across the capacitor C3 may track the voltage Vₛₑₜ-V_{offset}.

The driver 204 may need to both source current into and sink current from the capacitance C1 of the power amplifier supply. In the above described example the output stage of the driver 204 uses power FETs T1, T2 in push-pull configuration, and Vₐₘₚ is used as a voltage supply for the power amplifier 113. The driver supply voltage Vₚₒₛ may be tracking the upper bound to Vₐₘₚ to reduce voltage drop (power dissipation) over T1, and the driver supply voltage V_{neg} may be tracking the lower bound to Vₒᵤₜ to reduce voltage drop (power dissipation) over T2. For example, in dual-uplink carrier aggregation LTE (Long Term Evolution, a 4^{th} generation wireless communication technique), the bandwidth of the signal may be doubled in comparison to 20 MHz single-carrier LTE. For a given capacitance C1, the power losses in T2 from reverse current may at least double. As the power amplifier also draws a current i from Vₚₒₛ that helps to discharge C1, the actual losses for increased bandwidth may even be higher. A failure to discharge C1 on time might cause memory effects in the envelope signal that may damage RF performance (i.e. asymmetric spectral regrowth).

It should be noted here that above described embodiment of the second switching-mode power supply 208 is only an example and may also be implemented in a different way to produce an element which may provide a voltage to the negative voltage input of the driver 204 which follows the lower bound at a sufficient accuracy and speed.

In accordance with an embodiment, the upper bound i.e. the sum of the target voltage and the offset voltage Vₛₑₜ+V_{offset} and/or the lower bound i.e. the target voltage subtracted by the offset voltage Vₛₑₜ-V_{offset} may be generated digitally e.g. by the processor 102 or another element of the device 100 and connected to the first switching-mode power supply 202 and the second switching-mode power supply 208, respectively, through digital-to-analog converter(s). Hence, the adder 210 and the subtractor 212 may not be needed.

In accordance with an embodiment, the upper bound and the lower bound may be widened e.g. digitally, wherein the voltage waveforms of the upper bound, the lower bound and the target voltage Vₛₑₜ may resemble a combination of time shifted replicas of the target voltage Vₛₑₜ. An example of this is illustrated in Figure 3b. This kind of operation may be called as time-widening the target voltage.

In accordance with an embodiment, the same value for the offset voltage V_{offset} need not be used in generating the upper bound and the lower bound. In other words, the difference between the target voltage and the upper bound may be different from the difference between the target voltage and the lower bound.

In accordance with an embodiment, the apparatus 200 may reduce unwanted power dissipation in envelope tracking implementations and may enable scaling of the architecture to wider bandwidths as may be required for dual-uplink carrier aggregation. Further, bandwidth / power dissipation offset may be configurable via digital parameters, if digital production of the lower and upper bound voltages is used, and may allow smooth scaling for LTE where bandwidth can scale by a factor of more than 200, because the number of active resource blocks (RB) may be from one to 2 x 100 (1 RB ... 2 x 100 RB).

In LTE based systems downlink and uplink transmissions are organized into frames of certain duration (10 ms). According to the standard 3GPP TS 36.211 version 10.0.0 release 10, frames are divided into ten subframes, which may further be divided into two slots. In time domain a slot is one resource block long. A resource block is the smallest unit of resources that can be allocated to a user. The bandwidth of the resource block is 180 kHz. In frequency, resource blocks are composed of either 12 x 15 kHz subcarriers or 24 x 7.5 kHz subcarriers.

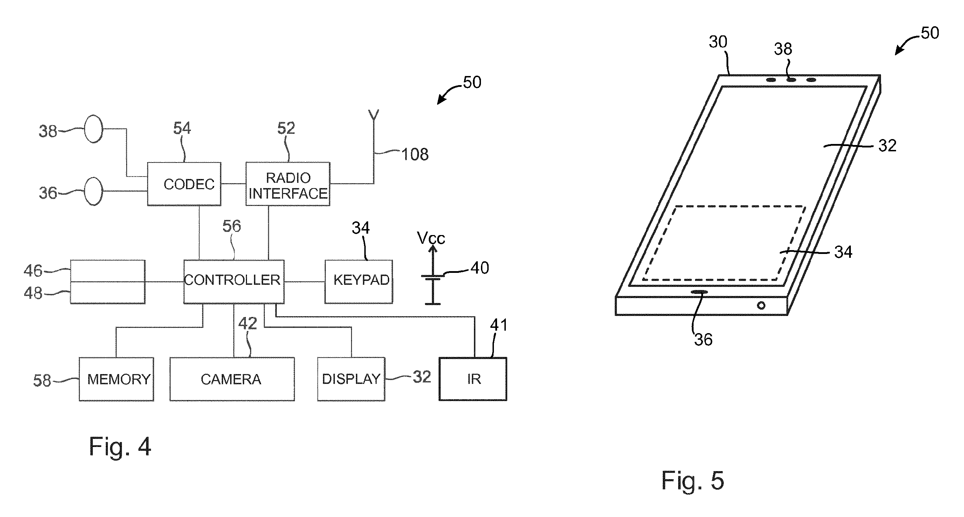

The following describes in further detail suitable apparatus and possible mechanisms for implementing the embodiments of the invention. In this regard reference is first made to Figure 4 which shows a schematic block diagram of an exemplary apparatus or electronic device 50 depicted in Figure 5, which may incorporate a transmitter according to an embodiment of the invention.

The electronic device 50 may for example be a mobile terminal or user equipment of a wireless communication system. However, it would be appreciated that embodiments of the invention may be implemented within any electronic device or apparatus which may require transmission of radio frequency signals.

The apparatus 50 may comprise a housing 30 for incorporating and protecting the device. The apparatus 50 further may comprise a display 32 in the form of a liquid crystal display. In other embodiments of the invention the display may be any suitable display technology suitable to display an image or video. The apparatus 50 may further comprise a keypad 34. In other embodiments of the invention any suitable data or user interface mechanism may be employed. For example the user interface may be implemented as a virtual keyboard or data entry system as part of a touch-sensitive display. The apparatus may comprise a microphone 36 or any suitable audio input which may be a digital or analogue signal input. The apparatus 50 may further comprise an audio output device which in embodiments of the invention may be any one of: an earpiece 38, speaker, or an analogue audio or digital audio output connection. The apparatus 50 may also comprise a battery 40 (or in other embodiments of the invention the device may be powered by any suitable mobile energy device such as solar cell, fuel cell or clockwork generator). The term battery discussed in connection with the embodiments may also be one of these mobile energy devices. Further, the apparatus 50 may comprise a combination of different kinds of energy devices, for example a rechargeable battery and a solar cell. The apparatus may further comprise an infrared port 41 for short range line of sight communication to other devices. In other embodiments the apparatus 50 may further comprise any suitable short range communication solution such as for example a Bluetooth wireless connection or a USB/firewire wired connection.

The apparatus 50 may comprise a controller 56 or processor for controlling the apparatus 50. The controller 56 may be connected to memory 58 which in embodiments of the invention may store both data and/or may also store instructions for implementation on the controller 56. The controller 56 may further be connected to codec circuitry 54 suitable for carrying out coding and decoding of audio and/or video data or assisting in coding and decoding carried out by the controller 56.

The apparatus 50 may further comprise a card reader 48 and a smart card 46, for example a UICC reader and UICC for providing user information and being suitable for providing authentication information for authentication and authorization of the user at a network.

The apparatus 50 may comprise radio interface circuitry 52 connected to the controller and suitable for generating wireless communication signals for example for communication with a cellular communications network, a wireless communications system or a wireless local area network. The apparatus 50 may further comprise an antenna 108 connected to the radio interface circuitry 52 for transmitting radio frequency signals generated at the radio interface circuitry 52 to other apparatus(es) and for receiving radio frequency signals from other apparatus(es).

In some embodiments of the invention, the apparatus 50 comprises a camera 42 capable of recording or detecting imaging.

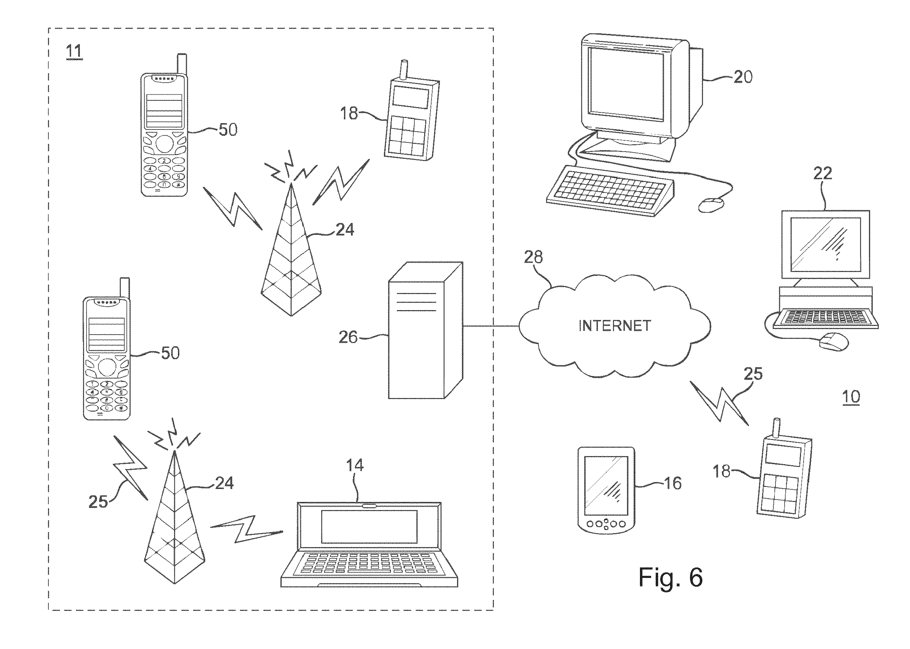

With respect to Figure 6, an example of a system within which embodiments of the present invention can be utilized is shown. The system 10 comprises multiple communication devices which can communicate through one or more networks. The system 10 may comprise any combination of wired and/or wireless networks including, but not limited to a wireless cellular telephone network (such as a GSM, UMTS, CDMA network etc.), a wireless local area network (WLAN) such as defined by any of the IEEE 802.x standards, a Bluetooth personal area network, an Ethernet local area network, a token ring local area network, a wide area network, and the Internet.

For example, the system shown in Figure 6 shows a mobile telephone network 11 and a representation of the internet 28. Connectivity to the internet 28 may include, but is not limited to, long range wireless connections, short range wireless connections, and various wired connections including, but not limited to, telephone lines, cable lines, power lines, and similar communication pathways.

The example communication devices shown in the system 10 may include, but are not limited to, an electronic device or apparatus 50, a combination of a personal digital assistant (PDA) and a mobile telephone 14, a PDA 16, an integrated messaging device (IMD) 18, a desktop computer 20, a notebook computer 22, a tablet computer. The apparatus 50 may be stationary or mobile when carried by an individual who is moving. The apparatus 50 may also be located in a mode of transport including, but not limited to, a car, a truck, a taxi, a bus, a train, a boat, an airplane, a bicycle, a motorcycle or any similar suitable mode of transport.

Some or further apparatus may send and receive calls and messages and communicate with service providers through a wireless connection 25 to a base station 24. The base station 24 may be connected to a network server 26 that allows communication between the mobile telephone network 11 and the internet 28. The system may include additional communication devices and communication devices of various types.

The communication devices may communicate using various transmission technologies including, but not limited to, code division multiple access (CDMA), global systems for mobile communications (GSM), universal mobile telecommunications system (UMTS), time divisional multiple access (TDMA), frequency division multiple access (FDMA), transmission control protocol-internet protocol (TCP-IP), short messaging service (SMS), multimedia messaging service (MMS), email, instant messaging service (IMS), Bluetooth, IEEE 802.11, Long Term Evolution wireless communication technique (LTE) and any similar wireless communication technology. A communications device involved in implementing various embodiments of the present invention may communicate using various media including, but not limited to, radio, infrared, laser, cable connections, and any suitable connection. In the following some example implementations of apparatuses utilizing the present invention will be described in more detail.

Although the above examples describe embodiments of the invention operating within a wireless communication device, it would be appreciated that the invention as described above may be implemented as a part of any apparatus comprising a circuitry in which radio frequency signals are transmitted and received. Thus, for example, embodiments of the invention may be implemented in a mobile phone, in a base station, in a computer such as a desktop computer or a tablet computer comprising radio frequency communication means (e.g. wireless local area network, cellular radio, etc.).

In general, the various embodiments of the invention may be implemented in hardware or special purpose circuits or any combination thereof. While various aspects of the invention may be illustrated and described as block diagrams or using some other pictorial representation, it is well understood that these blocks, apparatus, systems, techniques or methods described herein may be implemented in, as non-limiting examples, hardware, software, firmware, special purpose circuits or logic, general purpose hardware or controller or other computing devices, or some combination thereof.

Embodiments of the inventions may be practiced in various components such as integrated circuit modules. The design of integrated circuits is by and large a highly automated process. Complex and powerful software tools are available for converting a logic level design into a semiconductor circuit design ready to be etched and formed on a semiconductor substrate.

Programs, such as those provided by Synopsys, Inc. of Mountain View, California and Cadence Design, of San Jose, California automatically route conductors and locate components on a semiconductor chip using well established rules of design as well as libraries of pre stored design modules. Once the design for a semiconductor circuit has been completed, the resultant design, in a standardized electronic format (e.g., Opus, GDSII, or the like) may be transmitted to a semiconductor fabrication facility or "fab" for fabrication.

The foregoing description has provided by way of exemplary and non-limiting examples a full and informative description of the exemplary embodiment of this invention. However, various modifications and adaptations may become apparent to those skilled in the relevant arts in view of the foregoing description, when read in conjunction with the accompanying drawings and the appended claims. However, all such and similar modifications of the teachings of this invention will still fall within the scope of this invention.

In the following some examples will be provided.

According to a first example, there is provided a method comprising:
producing a first reference signal having a level above a target signal;
producing a second reference signal having a level below the target signal;
providing a positive supply voltage that tracks the first reference signal to a driver;
providing a negative supply voltage that tracks the second reference signal to the driver; and
supplying a signal corresponding to the target signal to a power amplifier from the driver.

In some embodiments the method comprises at least one of the following:
generating the target signal on the basis of a signal to be transmitted.

In some embodiments the method comprises:
generating the positive supply voltage with a first switching converter; and
generating the negative supply voltage with a second switching converter.

In some embodiments the method comprises:
generating the positive supply voltage with a buck-boost type switching converter; and
generating the negative supply voltage with a boost type switching converter.

In some embodiments the method comprises:
time-widening the target signal; and
producing the first reference signal and the second reference signal on the basis of the time-widened target signal.

According to a second example, there is provided an apparatus comprising:
a first element for producing a first reference signal having a level above a target signal;
a second element for producing a second reference signal having a level below the target signal;
a third element for providing a positive supply voltage that tracks the first reference signal to a driver;
a fourth element for providing a negative supply voltage that tracks the second reference signal to the driver;
wherein the driver comprises an output for supplying a signal corresponding to the target signal to a power amplifier.

In some embodiments the apparatus is adapted to:
generate the target signal on the basis of a signal to be transmitted.

In some embodiments of the apparatus:
a third element comprises a first switching converter; and
a fourth element comprises a second switching converter.

In some embodiments of the apparatus:
the first switching converter is a buck-boost type switching converter; and
the second switching converter is a boost type switching converter.

In some embodiments the apparatus further comprises:
an input for receiving an offset signal;
wherein the first element is adapted to produce the first reference signal on the basis of the offset signal and the target signal; and
the second element is adapted to produce the second reference signal on the basis of the offset signal and the target signal.

In some embodiments the apparatus further comprises:
a digital to analog converter for producing the offset signal.

In some embodiments the apparatus comprises:
a fifth element for time-widening the target signal;
wherein the apparatus is adapted to produce the first reference signal and the second reference signal on the basis of the time-widened target signal.

In some embodiments the driver is a linear amplifier.

In some embodiments the apparatus is a part of a wireless communication device.

According to a third example, there is provided an apparatus comprising at least one processor and at least one memory including computer program code, the at least one memory and the computer program code configured to, with the at least one processor, cause the apparatus to:
produce a first reference signal having a level above a target signal; and
produce a second reference signal having a level below the target signal;
wherein the apparatus is adapted to:
   provide a positive supply voltage that tracks the first reference signal to a driver;
   provide a negative supply voltage that tracks the second reference signal to the driver; and
   supply a signal corresponding to the target signal to a power amplifier from the driver.

In some embodiments of the apparatus said at least one memory including computer program code, the at least one memory and the computer program code configured to, with the at least one processor, cause the apparatus to:
generate the target signal on the basis of a signal to be transmitted.

In some embodiments of the apparatus said at least one memory including computer program code, the at least one memory and the computer program code configured to, with the at least one processor, cause the apparatus to:
generate the positive supply voltage with a first switching converter; and
generate the negative supply voltage with a second switching converter.

In some embodiments of the apparatus said at least one memory including computer program code, the at least one memory and the computer program code configured to, with the at least one processor, cause the apparatus to:
generate the positive supply voltage with a buck-boost type switching converter; and
generate the negative supply voltage with a boost type switching converter.

In some embodiments of the apparatus said at least one memory including computer program code, the at least one memory and the computer program code configured to, with the at least one processor, cause the apparatus to:
time-widening the target signal; and
produce the first reference signal and the second reference signal on the basis of the time-widened target signal.

According to a fourth example, there is provided a computer program product including one or more sequences of one or more instructions which, when executed by one or more processors, cause an apparatus to at least perform the following:
produce a first reference signal having a level above a target signal; and
produce a second reference signal having a level below the target signal;
wherein the apparatus is adapted to:
   provide a positive supply voltage that tracks the first reference signal to a driver;
   provide a negative supply voltage that tracks the second reference signal to the driver; and
   supply a signal corresponding to the target signal to a power amplifier from the driver.

According to a fifth example, there is provided an apparatus comprising:
means for producing a first reference signal having a level above a target signal; and
means for producing a second reference signal having a level below the target signal;
means for providing a positive supply voltage that tracks the first reference signal to a driver;
means for providing a negative supply voltage that tracks the second reference signal to the driver; and
means for supplying a signal corresponding to the target signal to a power amplifier from the driver.

## Claims

1. A method comprising:
producing a first reference signal having a level above a target signal;
producing a second reference signal having a level below the target signal;
providing a positive supply voltage that tracks the first reference signal to a driver;
providing a negative supply voltage that tracks the second reference signal to the driver; and
supplying a signal corresponding to the target signal to a power amplifier from the driver.

2. The method according to claim 1 comprising:
generating the target signal on the basis of a signal to be transmitted.

3. The method according to claim 1 or 2 comprising:
generating the positive supply voltage with a first switching converter; and
generating the negative supply voltage with a second switching converter.

4. The method according to claim 3 comprising at least one of the following:
generating the positive supply voltage with a buck-boost type switching converter; and
generating the negative supply voltage with a boost type switching converter.

5. The method according to any of the claims 1 to 4 comprising:
time-widening the target signal; and
producing the first reference signal and the second reference signal on the basis of the time-widened target signal.

6. An apparatus comprising:
a first element for producing a first reference signal having a level above a target signal;
a second element for producing a second reference signal having a level below the target signal;
a third element for providing a positive supply voltage that tracks the first reference signal to a driver;
a fourth element for providing a negative supply voltage that tracks the second reference signal to the driver;
wherein the driver comprises an output for supplying a signal corresponding to the target signal to a power amplifier.

7. The apparatus according to claim 6, wherein the apparatus is adapted to:
generate the target signal on the basis of a signal to be transmitted.

8. The apparatus according to claim 6 or 7 further comprising:
a third element comprises a first switching converter; and
a fourth element comprises a second switching converter.

9. The apparatus according to claim 8, wherein:
the first switching converter is a buck-boost type switching converter; and
the second switching converter is a boost type switching converter.

10. The apparatus according to any of the claims 6 to 9 further comprising:
an input for receiving an offset signal;
wherein the first element is adapted to produce the first reference signal on the basis of the offset signal and the target signal; and
the second element is adapted to produce the second reference signal on the basis of the offset signal and the target signal.

11. The apparatus according to claim 10 further comprising:
a digital to analog converter for producing the offset signal.

12. The apparatus according to any of the claims 6 to 11 further comprising:
a fifth element for time-widening the target signal;
wherein the apparatus is adapted to produce the first reference signal and the second reference signal on the basis of the time-widened target signal.

13. An apparatus comprising at least one processor and at least one memory including computer program code, the at least one memory and the computer program code configured to, with the at least one processor, cause the apparatus to:
produce a first reference signal having a level above a target signal; and
produce a second reference signal having a level below the target signal;
wherein the apparatus is adapted to:
provide a positive supply voltage that tracks the first reference signal to a driver;
provide a negative supply voltage that tracks the second reference signal to the driver; and
supply a signal corresponding to the target signal to a power amplifier from the driver.

14. A computer program product including one or more sequences of one or more instructions which, when executed by one or more processors, cause an apparatus to at least perform the following:
produce a first reference signal having a level above a target signal; and
produce a second reference signal having a level below the target signal;
wherein the apparatus is adapted to:
provide a positive supply voltage that tracks the first reference signal to a driver;
provide a negative supply voltage that tracks the second reference signal to the driver; and
supply a signal corresponding to the target signal to a power amplifier from the driver.

15. An apparatus comprising:
means for producing a first reference signal having a level above a target signal; and
means for producing a second reference signal having a level below the target signal;
means for providing a positive supply voltage that tracks the first reference signal to a driver;
means for providing a negative supply voltage that tracks the second reference signal to the driver; and
means for supplying a signal corresponding to the target signal to a power amplifier from the driver.
